(19) Europäisches Patentamt
European Patent Office
Office européen des brevets

(11) **EP 2 141 585 A1**

(12) **EUROPEAN PATENT APPLICATION**

(43) Date of publication:
**06.01.2010 Bulletin 2010/01**

(51) Int Cl.:
**G06F 7/53** (2006.01)

(21) Application number: **08159287.5**

(22) Date of filing: **27.06.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Panasonic Corporation**
**Kadoma-shi**
**Osaka 571-8501 (JP)**

(72) Inventor: **Stansfield, Anthony**
**Kadoma-shi Osaka 571-0051 (JP)**

(74) Representative: **Haley, Stephen**
**Gill Jennings & Every LLP**
**Broadgate House**
**7 Eldon Street**
**London EC2M 7LH (GB)**

(54) **Combined adder circuit array and and/or plane**

(57)    A method of modifying a group of full adder circuits to compute a Boolean function of a set number of input bits, each full adder circuit having first and second data inputs, a data output, a carry input and a carry output, the full adder circuits being interconnected so as to form a carry chain. The method comprises the steps of setting the first input of each full adder circuit to a same fixed value, connecting each respective input bit of the set number of input bits to the second input of a respective one of the full adder circuits and using the output of the carry chain of the array of full adder circuits as the result of the Boolean function.

FIGURE 1

**Description**

The present invention is directed to a dedicated logic circuit which can act as either an array of adder circuits for use in, for example, a multiplier circuit or an AND/OR plane.

Reconfigurable devices/fabrics are commonly constructed from multiple instances of a single user programmable logic block or tile, the fundamental building block of the system. This arrangement facilitates the use of an easily scalable configuration mechanism of equally regular structure.

The insertion of dedicated functional blocks embedded within a reconfigurable device/fabric is often used to enhance the performance of the device/fabric within a specific application context.

However, these dedicated blocks are only useful in applications which require the particular function that they provide. For other applications, they represent an added cost for little or no benefit. This is particularly the case for multipliers and Programmable Logic Arrays (PLAs). Multipliers are only useful in data processing applications, whereas PLAs are principally control structures and are of very limited use to datapaths.

Moreover, a problem arises when a decision must be made in respect of where to place the functional blocks. For example, if a single reconfigurable circuit is to be used for two different applications, it may be desirable to have localised clusters of PLAs and multipliers for one application and an even distribution of multipliers and PLAs for another. The problem which arises is therefore that of finding the best distribution of PLAs and multipliers which will optimise the circuit for each application.

Partial solutions to these problems have been provided in the form of set distributions of PLAs and multipliers across an array. These set distributions could, for example be homogeneous distributions of multipliers and PLAs. However, this only partially solves the above problems in that, were a specific configuration to need a certain number of multipliers in a particular area of the array, and that certain number exceeded the number of multipliers in that particular area of the set distribution, other multipliers would need to be used outside that area, thereby increasing the routing complexity of the circuit.

In order to provide a more complete solution to the above problems, standard "families" of programmable logic devices were created, each having different numbers of each type of embedded block. Each application has a specific requirement in terms of multipliers and PLAs. However, applications can be grouped together in application domains, each application domain sharing a number of characteristics. It is therefore possible to produce a finite number of different template devices, each of which is particularly well suited to one application domain. However, although the production of these families does increase the variety of architectures from a single set distribution to a finite set of configurations, this solution still falls short of providing the flexibility of a wholly application specific configuration.

Accordingly, there exists a clear need for a dedicated logic circuit which can be easily re-configured to function as either a multiplier or an AND/OR plane.

In order to overcome the problems associated with the prior art, the present invention provides a method of modifying a group of full adder circuits to compute a Boolean function of a set number of input bits, each full adder circuit having first and second data inputs, a data output, a carry input and a carry output, the full adder circuits being interconnected so as to form a carry chain, the method comprises the steps of:

setting the first input of each full adder circuit to a same fixed value;
connecting each respective input bit of the set number of input bits to the second input of a respective one of the full adder circuits; and
using the output of the carry chain of the array of full adder circuits as the result of the Boolean function.

The fixed value may be logic LOW and the Boolean function an AND or NAND.

The fixed value may be a logic HIGH and the Boolean function an OR or NOR.

Each full adder circuit may form part of a Booth multiplier.

The present invention further provides an apparatus for modifying a group of full adder circuits to compute a Boolean function of a set number of input bits, each full adder circuit having first and second data inputs, a data output, a carry input and a carry output, the full adder circuits being interconnected so as to form a carry chain, the apparatus comprises:

setting means for setting the first input of each full adder circuit to a same fixed value;
connecting means for connecting each respective input bit of the set number of input bits to the second input of a respective one of the full adder circuits; and
propagating means for propagating the output of the carry chain of the array of full adder circuits as the result of the Boolean function.

The fixed value may be logic LOW and the Boolean function an AND or NAND.

The fixed value may be a logic HIGH and the Boolean function an OR or NOR.

Each full adder circuit may form part of a Booth multiplier.

As will be appreciated, the present invention provides several advantages over the prior art. For example, the present invention requires fewer embedded units overall and solves the problems associated with having to decide the relative distribution of the AND/OR planes and multipliers across the array or the cost of having to increase the network routing area. For example, if a specific application domain requires a total of 100 multipliers and/or AND/OR planes in total but the specific applications within the application domains require ratios varying from 25 multipliers : 75 AND/OR planes to 75 multipliers : 25 AND/OR planes. According to the solutions provided by the prior art, for a single device to run every application, that device would need to comprise 75 AND/OR planes and 75 multipliers (150 units in total). However, a device designed in accordance with the present invention would not need more than 100 units in total. Thus, a device in accordance with the present invention clearly requires fewer embedded units. Moreover, the present invention provides flexibility in regard to the distribution of multipliers and AND/OR planes in that any single unit can function either as a multiplier or as an AND/OR plane.

Examples of the present invention will now be described with reference to the accompanying drawings, in which:

Figure 1 represents a high level block diagram of a 4x4 unsigned binary multiplier circuit in accordance with an example of the present invention;
Figure 2 represents an alternate view of the high level block diagram of Figure 1;
Figure 3 represents a logic diagram of a adder circuit of the 4x4 unsigned binary multiplier circuit of Figure 1 and 2;
Figure 4 represents a high level block diagram of a Booth multiplier circuit in accordance with another example of the present invention;
Figure 5 represents a logic diagram of an adder circuit of the Booth multiplier circuit of Figure 6;
Figure 6 represents a more detailed block diagram of the Booth multiplier circuit in accordance with another example of the present invention;
Figure 7 represents a carry bypass adder circuit in accordance with another example of the present invention;
Figure 8 represents a carry bypass tree circuit in accordance with another example of the present invention;
Figure 9 represents a carry look ahead circuit in accordance with another example of the present invention;
Figure 10 represents an alternative implementation to the circuit of Figure 9; and
Figure 11 represents an alternative implementation to the circuit of Figure 9,

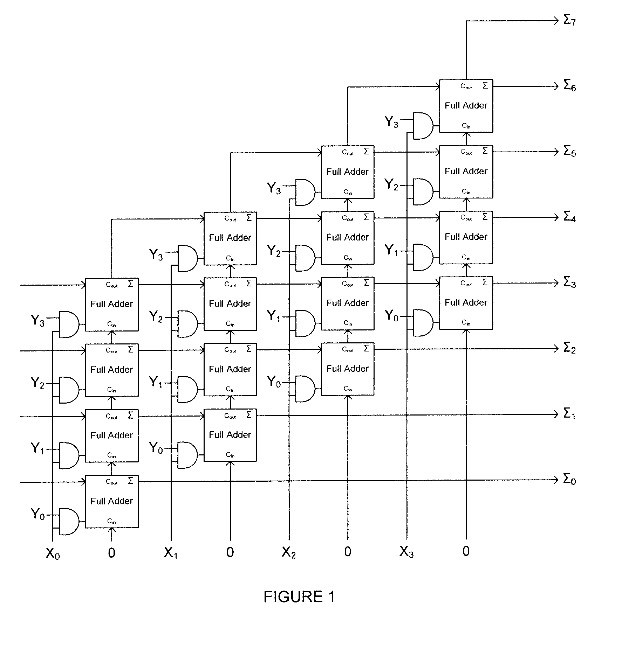

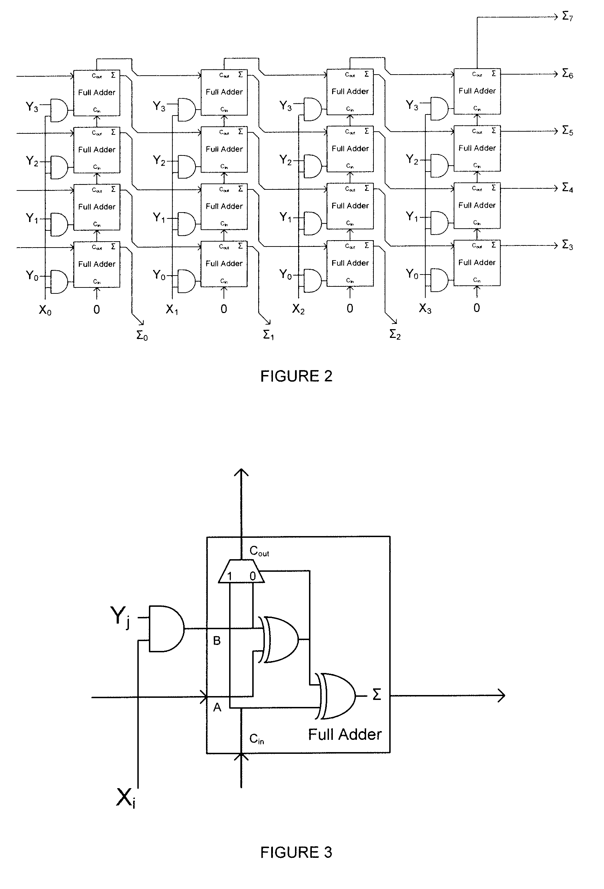

With reference to Figure 1, a first example of the present invention will now be described. Figure 1 represents a high level block diagram of a possible implementation of a 4x4 unsigned binary multiplier. Each adder circuit in the circuit of Figure 1 comprises a full adder. Figure 2 is an alternate view of the circuit of Figure 1 and Figure 3 is a more detailed representation of a single adder circuit of the circuits of Figures 1 and 2.

As can be seen from Figure 2, the X and Y inputs of the circuit run vertically and horizontally, respectively. The carries ($C_{out}$) also run vertically and the sums ($\Sigma$) run diagonally.

Now, with reference to Figure 3, the resulting circuit implements the following logic equations:

$$\sum = A \oplus B \oplus C_{in}$$
$$= (X \bullet Y) \oplus B \oplus C_{in}$$

$$C_{out} = (A \oplus B)?C_{in}:B$$
$$= ((X \bullet Y) \oplus B)?C_{in}:B$$

Now, if B (the running total input) is forced to 0 in each adder cell, then:

$$C_{out} = A?C_{in}:0$$
$$= A \bullet C_{in}$$
$$= (X \bullet Y) \bullet C_{in}$$

Because $C_{out}$ of each cell connects to $C_{in}$ of another cell, along a row of cells it can be seen that:

$$C_{out} = A\,?\,C_{in}\!:\!0$$
$$= A \bullet C_{in}$$
$$= (X \bullet Y)_i \bullet (X \bullet Y)_j \bullet (X \bullet Y)_k \dots$$

Thus, it can be seen that, when B is forced to 0, $C_{out}$ is an AND function of a set of input bits. Similarly, if B is now forced to 1, it can be shown that:

$$C_{out} = (A \oplus 1)\,?\,C_{in}\!:\!1$$
$$= \overline{A}\,?\,C_{in}\!:\!1$$
$$= A\,?\,1\!:\!C_{in}$$
$$= A\,|\,C_{in}$$
$$= (X \bullet Y)\,|\,C_{in}$$
$$= (X \bullet Y)_i\,|\,(X \bullet Y)_j\,|\,(X \bullet Y)_k\,|\dots$$

Thus, it can be seen that, when B is forced to 1, $C_{out}$ is an OR function of a set of input bits.

Accordingly, by constraining the values of B to either a 0 or a 1, thereby effectively blocking sum propagation in the multiplier array, it is possible to generate AND and OR functions via the carry chains. As will be appreciated, the AND and OR functions are the fundamental building blocks of a sum-of-products implementation of a logic function, as implemented in Programmable Logic Arrays (PLAs).

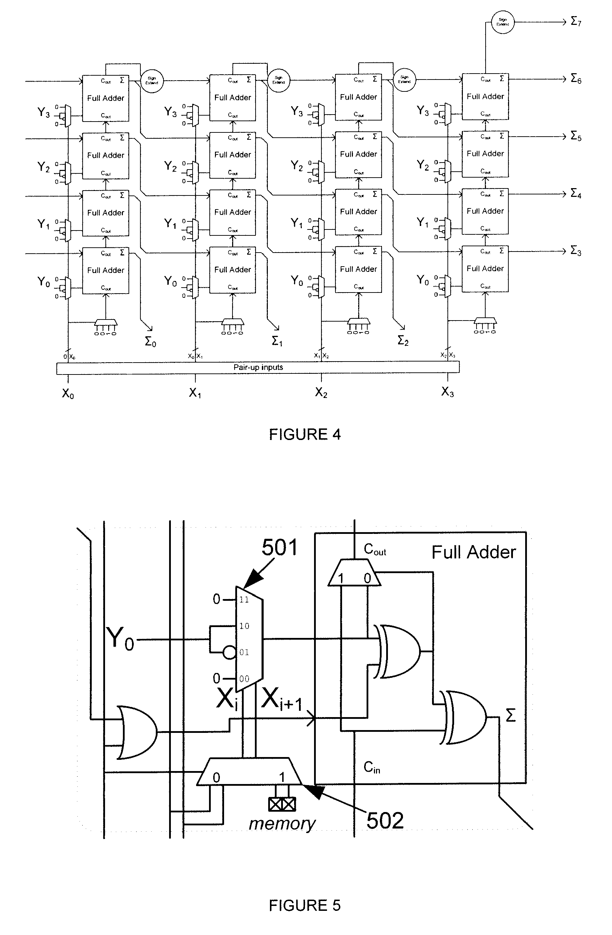

Now, with reference to Figures 4 and 5 a second example of the present invention will now be described. Figure 4 represents a modified Booth-encoded multiplier in accordance with the present invention. Figure 5 represents a modified adder circuit of the Booth-encoded multiplier of Figure 4.

In a Booth-encoded multiplier, the adder circuits are modified so that, at each stage, one of three operations is performed. The first operation is that of adding a shifted version of an input to the running total. The second operation is that of subtracting a shifted version of an input from the running total. Finally, the final step is that of propagating an unchanged running total.

In order to implement a subtraction, one of the inputs is inverted and the $C_{in}$ of the least significant adder circuit is set to 1. This can be done because, in 2's complement arithmetic, -Y is represented as NOT (Y) +1.

Figure 5 shows a modified adder circuit for a Booth multiplier. Although the basic structure of the adder circuit of Figure 5 is similar to that of the previous example, a multiplexer is added in order to select the appropriate value to add.

The adder circuit of Figure 3 has been modified so that all adder circuits can have different effective values of the signals labelled $X_i$ and $X_{i+1}$. In known multipliers, these signals are typically shared between all adders in a column. However, in order for the outputs of the various OR-plane functions to be different, it is necessary to allow these signals to be set independently. Accordingly, the example shown in Figure 5 includes two configuration bits which allow these signals to be locally set. These adders connect to the multiplier select inputs, allowing Y, NOT(Y) or 0 to be chosen as the output of the multiplexer. Figure 5 shows this modified adder, where the control of the input multiplexer 501 comes from $X_i$ and $X_{i+1}$ and from two configuration bits in the case of the OR-plane. The choice is controlled by a third configuration bit (shared amongst all such cells), which controls the overall mode of operation. Thus, in this example, when the multiplexer 502 is set to 0, the values of $X_i$ and $X_{i+1}$ are input from the shared external source and when the multiplexer 502 is set to 1, the values of $X_i$ and $X_{i+1}$ are input from local memory.

As can be seen from Figure 5, the Booth multiplier cell has connections to both Y and NOT(Y). When this input is constrained in the manner described in the first example of the invention, this provides an alternative way of implementing the AND/OR functionality by making use of De Morgan's theorem. For example, using the OR functionality of the circuit, with B constrained to 1, the following modes of operation can be possible.

If the multiplexers 501 are set to pass their Y inputs, then the output will be an OR or multiple Y inputs, as expressed in the following equation.

$$C_{out} = Y_0 | Y_1 | ...$$

If however the multiplexers 501 are set to pass their not(Y) inputs, then the output will be an OR of multiple Y inputs, as expressed in the following equations.

$$C_{out} = !Y_0 | !Y_1 | ...$$

or

$$C_{out} = !(Y_0 \& Y_1 \& ...)$$

As can be seen from the above equations, the output can be viewed as a NAND function of the un-inverted inputs.
Finally, if only a proportion of the multiplexers 501 are set to pass their Y inputs, and others to pass their not (Y) inputs, the output will be a combination of NAND and OR functions, as expressed in the following equations.

$$Cout = Y_0 | !Y_1 | Y_2 | !Y_3 | ...$$

$$Cout = (Y_0 | Y_2) | !(Y_1 \& Y_3) | ...$$

Thus, in this example of the present invention, it is only necessary to constrain the B input to a single value in order to achieve both AND and OR functionality. Since, because the Booth multiplier can generate a constant 0 at the multiplexer output, but not a constant 1 (this is because A | 0 = A), it is preferable to use the OR form of the circuit described in the first example of the present invention, thereby constraining B to 1. This allows some of the Y input terms to be ignored in the output. Thus, it is also possible to construct functions of the following form.

$$Cout = Y_0 | 0 | Y_2 | Y_3 | ...$$

$$Cout = Y_0 | Y_2 | Y_3 | ...$$

or

$$Cout = !Y_0 | 0 | !Y_2 | !Y_3 | ...$$

$$Cout = !(Y_0 \& Y_2 \& Y_3 \& ...)$$

or

$$Cout = Y_0 |! Y_1 |0|! Y_3 |...$$

$$Cout = Y_0 |!\left( Y_1 \& Y_3 \right)|...$$

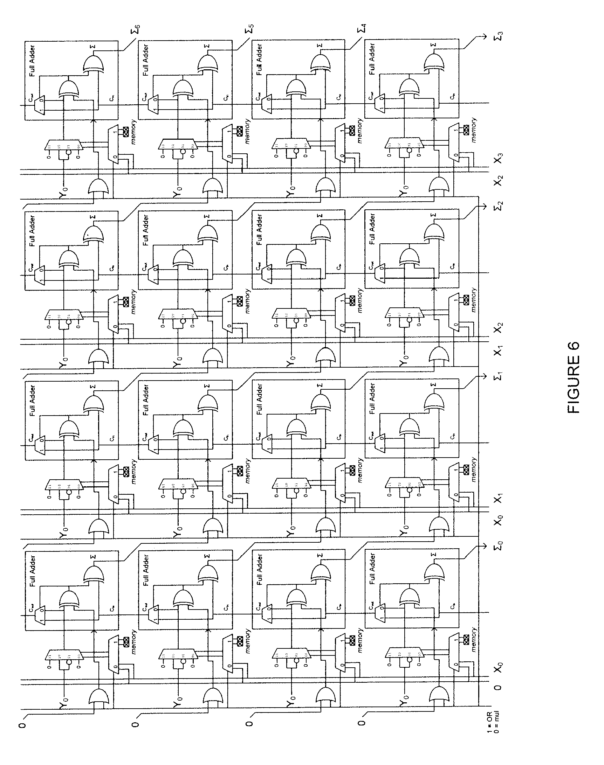

Figure 6 represents a full implementation of the Booth multiplier circuit in accordance with the present invention.

The equations representing the first and second embodiments of the present invention comprise a carry chain with a generate/propagate structure. Because of this, the carry output is either a copy of the carry input, propagated to the output, or a newly generated value (copied from the B input). The carry chain is determined by the following "propagate" signal:

$$P = A \oplus B$$
$$= ( X \bullet Y ) \oplus B$$

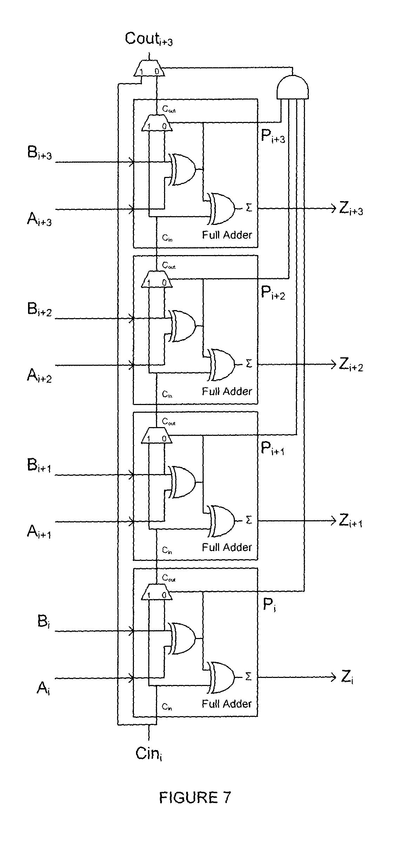

It is desirable to speed up carry propagation in a multi-bit adder by providing a bypass path, such that a carry signal can route around several single-bit stages. In the embodiment of Figure 7, the multiplexer needed to achieve this is controlled by a signal created by ANDing the P outputs of the individual stages. The circuit of Figure 7 performs a 4-bit section of $Z = A + B$. Each Pi signal is input into a 4-input AND gate. If all $C_{out}$ signals are set to HIGH, the multiplexer will select input 1, thereby propagating $C_{in\ i}$ to the $C_{out\ i+3}$. This circuit therefore selects a faster $C_{in\ i}$ to $C_{out\ i+3}$ path when the carry input would otherwise be propagated by all individual adders.

As will be appreciated, the constraining of B in the first two examples of the present invention is effectively a restriction on the carry value that can be generated. The carry chain of the present invention however operates in the same way as in an ordinary adder or multiplier. Thus, the carry bypass circuit disclosed above will be operable to speed up the propagation of the carry signals.

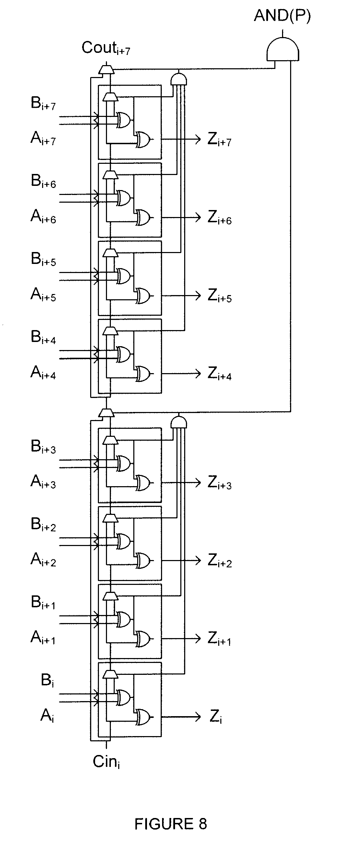

Alternatively, the output of the AND gate that controls the bypass multiplexer in Figure 7 can be used directly as part of a tree of gates to generate an AND of all the P signals in a wider adder. Figure 8 shows a circuit which accomplishes this. Effectively, the circuit of Figure 8 comprises two circuits in accordance with Figure 7. However, the outputs of the AND gates of the circuits are themselves input into an AND gate, the output of which can be used as the logic function output.

An alternative method of speeding up carry circuits for multi-bit adders is to use a carry look ahead circuit. If the equation for a carry bit is expanded across several adder bits, the result is an equation with more terms but that can be built as a simple tree of AND and OR gates. A circuit to implement this equation is faster than the ripple carry circuit described above, though it is also larger. For example, a two-stage carry look ahead circuit is represented by the following equation:

$$C_{i+1} = \left( A_i \oplus B_i \right)? C_i : B$$
$$= A_i B_i | A_i C_i | B_i C_i$$

$$C_{i+2} = A_{i+1} B_{i+1} | A_{i+1} C_{i+1} | B_{i+1} C_{i+1}$$
$$= A_{i+1} B_{i+1} | A_{i+1} \left( A_i B_i | A_i C_i | B_i C_i \right) B_{i+1} \left( A_i B_i | A_i C_i | B_i C_i \right)$$
$$= A_{i+1} B_{i+1} | A_{i+1} A_i B_i | A_{i+1} A_i C_i | A_{i+1} B_i C_i | A_i B_{i+1} B_i | A_i B_{i+1} C_i | B_{i+1} B_i C_i$$

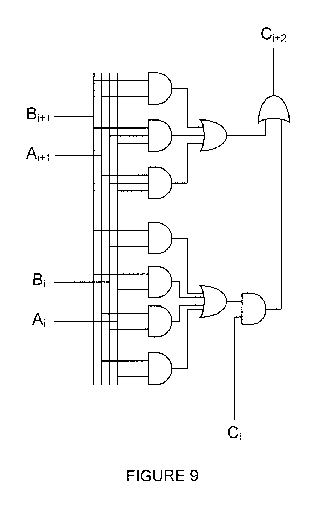

A circuit implementing the above equation is shown in Figure 9. When constrained to a fixed value of B = 1, it can be sown that:

$$\left( A_{i+1} B_{i+1} \middle| A_{i+1} A_i B_i \middle| A_i B_{i+1} B_i \right)_{B=1} = \left( A_{i+1} \middle| A_{i+1} A_i \middle| A_i \right)$$

$$= A_{i+1} \middle| A_i$$

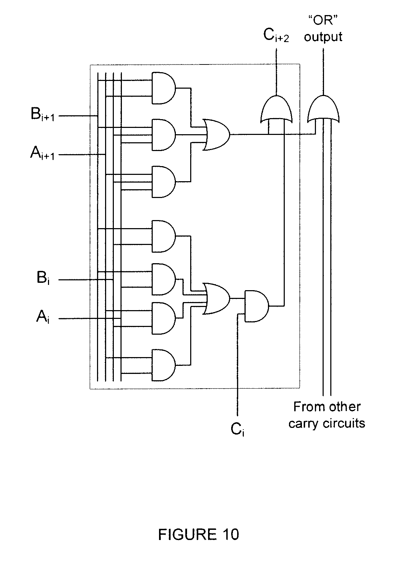

This provides an alternative implementation of an OR function of the A inputs. Instead of using the carry chain as described above, these nodes can be tapped directly and used as inputs to a dedicated tree of logic gates to generate the OR function. This implementation is shown in Figure 10.

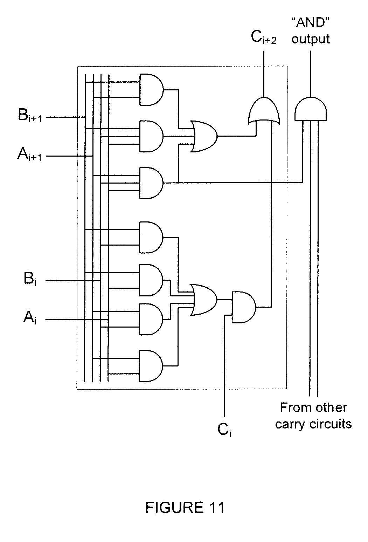

Similarly, because the above expression also contains a single Ai+1Ai term, it can also be tapped directly to drive the tree that generates an AND function of the A inputs, as shown in Figure 11. This implementation provides a way to generate an AND function while simultaneously generating an OR function via the carry chain. It also means that a single constraint value for B can be used to provide both AND and OR functions. Alternatively, in a Booth multiplier example, the complements of the inputs are also available to expand the range of available functions.

As will be appreciated, although the above embodiments comprise array multipliers, the present invention can be used with any other circuit which contains a large number of adder circuits interconnected to form a carry chain. Examples of such circuits include dividers and Finite-Impulse Response (FIR) filters.

**Claims**

1.  A method of modifying a group of full adder circuits to compute a Boolean function of a set number of input bits, each full adder circuit having first and second data inputs, a data output, a carry input and a carry output, the full adder circuits being interconnected so as to form a carry chain, the method comprising the steps of:

    setting the first input of each full adder circuit to a same fixed value;
    connecting each respective input bit of the set number of input bits to the second input of a respective one of the full adder circuits; and
    using the output of the carry chain of the array of full adder circuits as the result of the Boolean function.

2.  The method of claim 1, wherein the fixed value is logic LOW and the Boolean function is an AND or NAND.

3.  The method of claim 1, wherein the fixed value is a logic HIGH and the Boolean function if an OR or NOR.

4.  The method of claim 1, wherein each full adder circuit forms part of a Booth multiplier.

5.  An apparatus for modifying a group of full adder circuits to compute a Boolean function of a set number of input bits, each full adder circuit having first and second data inputs, a data output, a carry input and a carry output, the full adder circuits being interconnected so as to form a carry chain, the apparatus comprising:

    setting means for setting the first input of each full adder circuit to a same fixed value;
    connecting means for connecting each respective input bit of the set number of input bits to the second input of a respective one of the full adder circuits; and
    propagating means for propagating the output of the carry chain of the array of full adder circuits as the result of the Boolean function.

6.  The apparatus of claim 5, wherein the fixed value is logic LOW and the Boolean function is an AND or NAND.

7.  The apparatus of claim 5, wherein the fixed value is a logic HIGH and the Boolean function if an OR or NOR.

8.  The apparatus of claim 5, wherein each full adder circuit forms part of a Booth multiplier.

FIGURE 1

FIGURE 2

FIGURE 3

FIGURE 4

FIGURE 5

FIGURE 6

FIGURE 7

FIGURE 8

FIGURE 9

FIGURE 10

FIGURE 11

Europäisches
Patentamt

European
Patent Office

Office européen
des brevets

## EUROPEAN SEARCH REPORT

Application Number

EP 08 15 9287

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 570 039 A (OSWALD WILLIAM A [US] ET AL) 29 October 1996 (1996-10-29) | 5-8 | INV. G06F7/53 |
| A | * column 1, line 24 - column 5, line 45; figures 1,2 * | 1-4 | |
| A | CARDARILLI G C ET AL: "ADAPTO: full-adder based reconfigurable architecture for bit level operations" CIRCUITS AND SYSTEMS, 2008. ISCAS 2008. IEEE INTERNATIONAL SYMPOSIUM ON, IEEE, PISCATAWAY, NJ, USA, 18 May 2008 (2008-05-18), pages 3434-3437, XP031272233 ISBN: 978-1-4244-1683-7 Section IIIA | 1-8 | |
| A | YAMAGUCHI R ET AL: "A novel variable grain logic cell architecture with multifunctionality" TENCON 2007 - 2007 IEEE REGION 10 CONFERENCE, IEEE, PI, 30 October 2007 (2007-10-30), pages 1-4, XP031226120 ISBN: 978-1-4244-1271-6 * the whole document * | 1-8 | TECHNICAL FIELDS SEARCHED (IPC) G06F H03K |

The present search report has been drawn up for all claims

| Place of search | Date of completion of the search | Examiner |
|---|---|---|
| Munich | 3 December 2008 | Prins, Leendert |

## ANNEX TO THE EUROPEAN SEARCH REPORT
## ON EUROPEAN PATENT APPLICATION NO.

EP 08 15 9287

This annex lists the patent family members relating to the patent documents cited in the above-mentioned European search report.
The members are as contained in the European Patent Office EDP file on
The European Patent Office is in no way liable for these particulars which are merely given for the purpose of information.

03-12-2008

| Patent document cited in search report | | Publication date | Patent family member(s) | | Publication date |
|---|---|---|---|---|---|
| US 5570039 | A | 29-10-1996 | JP | 9050367 A | 18-02-1997 |

For more details about this annex : see Official Journal of the European Patent Office, No. 12/82